(19) Europäisches Patentamt
European Patent Office
Office européen des brevets

(11) **EP 3 764 499 B1**

(12) **EUROPEAN PATENT SPECIFICATION**

(45) Date of publication and mention
of the grant of the patent:
**24.07.2024 Bulletin 2024/30**

(21) Application number: **19193614.5**

(22) Date of filing: **26.08.2019**

(51) International Patent Classification (IPC):
**H02H 7/26** (2006.01)     **G01R 19/08** (2006.01)

(52) Cooperative Patent Classification (CPC):
**H02H 7/26; G01R 19/2513**

(54) **SYMMETRICAL FAULT DETECTION DURING POWER SWING CONDITION WITH SINGLE ENDED MEASUREMENTS**

SYMMETRISCHE FEHLERERKENNUNG WÄHREND DES LEISTUNGSPENDELZUSTANDS MIT EINSEITIGEN MESSUNGEN

DÉTECTION DE DÉFAUT SYMÉTRIQUE EN CAS D'OSCILLATION DE PUISSANCE À L'AIDE DE MESURES ASYMÉTRIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.07.2019 IN 201941027403**

(43) Date of publication of application:
**13.01.2021 Bulletin 2021/02**

(73) Proprietor: **Hitachi Energy Ltd**
**8050 Zürich (CH)**

(72) Inventors:
• **Pradhan, Vedanta**
**Bhubaneswar, Odisha 751024 (IN)**
• **Naidu, OD**
**Bangalore, Karnataka 560087 (IN)**
• **Srivastava, Sachin**
**Bangalore, Karnataka 560048 (IN)**
• **Maturu, Suresh**
**Cherukupalli, Andhra Pradesh 522309 (IN)**

(74) Representative: **Vossius & Partner**
**Patentanwälte Rechtsanwälte mbB**
**P.O. Box 86 07 67**
**81634 München (DE)**

(56) References cited:
**US-A1- 2009 089 608     US-A1- 2015 051 852**
**US-A1- 2016 299 187     US-B2- 6 571 182**

**Description**

TECHNICAL FIELD

The present subject matter relates, in general, to power transmission systems. More specifically, the present subject matter relates to approaches for detection of faults during power swing condition occurring in an electrical network.

BACKGROUND

Generally, power systems of electrical networks operate under steady-state conditions. In certain cases, the electrical networks may experience disturbances or faults in the transmission lines of the electrical network. As would be understood, during the occurrence of faults, the impedance being offered by a portion of the electrical network reduces and consequently the current increases to very high values. This may result in damages to components or systems which may be present in the electrical networks. The transmission lines may be provided with one or more Intelligent Electronic Devices (IEDs). IEDS can detect the fault based on comparison of the calculated impedance with reference values. Accordingly, circuit breakers provided on the transmission lines may be tripped in order to secure and isolate the portion of the electrical network experiencing the fault.

US 2016/0299187 A1 discloses methods directed to monitoring in real time, power system data so as to provide insights into global operation of a power grid. Such a scheme utilizes rules, which are created by analyzing PMU measurement data, in order to detect the fault location (bus and line) and fault type. Three common types of faults in a power grid, single-line-to-ground (SLG), line-to-line (LL), and three phase faults, can be detected.

BRIEF DESCRIPTION OF DRAWINGS

The features, aspects, and advantages of the present subject matter will be better understood with regards to the following description and accompanying figures. The use of the same reference number in different figures indicate similar or identical features and components.

FIG. 1 provides an illustration depicting an electrical network having an intelligent electronic device, as per one example;
FIG. 2 provides a block diagram of an example intelligent electronic device, as per one example;
FIGS. 3-7 provides illustrative graphs depicting occurrence of a three-phase fault during a power swing condition, the instantaneous values of current and further granular variations of corresponding phasor magnitudes, and corresponding detrended phasor magnitudes, as per one example; and

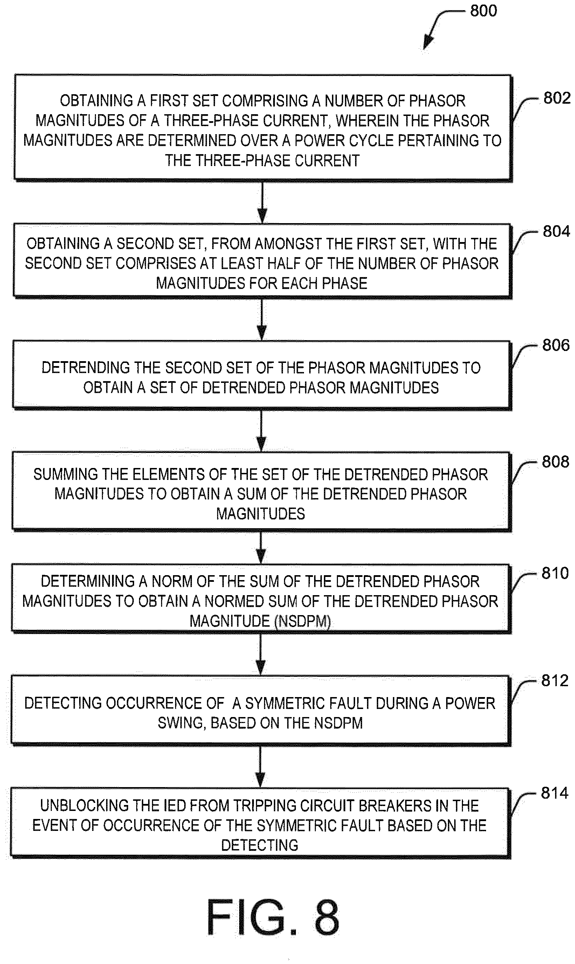

FIG. 8 provides a flow diagram depicting an example method for ascertaining the presence of a symmetric fault during the occurrence of a power swing within an electrical network.

It may be noted that throughout the drawings, identical reference numbers designate similar, but not necessarily identical, elements. The figures are not necessarily to scale, and the size of some parts may be exaggerated to more clearly illustrate the example shown. Moreover, the drawings provide examples and/or implementations consistent with the description; however, the description is not limited to the examples and/or implementations provided in the drawings. The invention is set out in the appended claims.

DETAILED DESCRIPTION

Electrical networks may be prone to faults, which tends to disturb the steady-state operating conditions of the power systems. Such faults may result in a sudden increase in the electrical current flowing through portions of the electrical network impacted by the fault. The increase in the electrical current may damage components present within the electrical network. When the impedance drops below a predefined value, an IED (e.g., a distance relay) may trip to prevent any damages that may result from the impedance drops experienced in the electrical network. Faults may be broadly categorized asymmetric and symmetric faults. Symmetrical faults or balanced faults, may be considered as such faults which impacts each of the three-phases of the electrical network equally and at the same time. Examples of such symmetric faults include, but are not limited to, line to line to line (L-L-L) and line to line to line to ground (L-L-L-G).

In certain circumstances, symmetric faults may occur during a condition commonly referred to as a power swing condition. During a power swing, the electrical network may tend to deviate from its otherwise steady-state operating condition. Particularly, inter-area power swings may result in large fluctuations of voltage, current and power between two areas of a power system, for example, areas that may be connected via tie lines. As is generally understood, System disturbances such as transmission line faults, loss of generator units, or switching operation of heavy loaded transmission lines, and such, may cause power swings. A power swing can lead to undesired trip of the distance relay, which may aggravate system instability.

It is possible that despite the occurrence of the power swing condition, the apparent impedance measured is within the operational limits. Or it may be the case that the power swing condition is such that it is recoverable within the system. If the IED is to trip the circuit breakers, the tripping may further cause an aggravated instability thereby disrupting the operation of the electrical network. In such cases, an Intelligent Electronic Device (IED) on detecting the occurrence of a power swing may block or prevent the tripping and may allow the power swing conditions to be resolved in the desired manner. It may be noted that detection and decision for tripping or blocking the tripping is done by the IED in short time windows, which may be in the order of a few milliseconds.

Asymmetric faults occurring during a power swing may be detected by the presence of a negative sequence current and a zerosequence current. An IED on detecting the presence of such currents may isolate the portion of electrical network experiencing such faults to prevent any damage to the electrical components. In case of a symmetric fault, owing to the symmetrical nature of the symmetrical faults, it is possible that such fault may go undetected during the occurrence of a power swing. Since the distance relays may be blocked from tripping during a power swing condition, if symmetrical faults occur during a power swing, it is likely that such a fault may go undetected and may result in high sustained currents through the various components and systems of electrical network.

Considering the above, it is desired that occurrence of such symmetric faults is detected and appropriate action be taken to avoid any damage to components within the electrical network. The manner of detection of such symmetric faults has typically involved determination of phasor magnitudes of current measurements corresponding to each phase of a three-phase electric current. In certain examples, occurrence of faults during power swing conditions have been determined based on defining 'blinder' zones within an impedance. However, such approaches require careful and precise configuration of the blinder positions with respect to the existing characteristics of the circuit within the electrical network. Other examples have also been relied on which involve determining rates of change of impedances within an electrical network, to ascertain the occurrence of a fault. In such other approaches, impedance may be continuously monitored. In one example, a discontinuity of the impedance trajectory is used to detect the occurrence of the fault. As has been observed, such examples are susceptible to errors owing to inaccurate impedance calculations which may arise due to phasor estimation errors that, in turn, may occur during power swing conditions.

Various other approaches may also be utilized for differentiating occurrence of symmetric faults and power swings. However, each of such approaches have been observed to have their own challenges. For example, rate of change of swing centre voltage and rate of change of measured resistance may be evaluated to differentiate a fault from a swing. However, it is observed that they may fail for implementations involving high resistance faults or in case of faults which occur near the swing center. In another approach, the phase angle relationship between oscillatory voltage and current magnitudes may be used to identify a fault. Such methods, however, depend heavily on the quality of the phasor estimates, especially after the fault when DC offsets and other high frequency transients are present in the voltages and currents. Alternatively, some approaches have relied on determining the difference between the actual measured samples and the samples reconstructed from the dynamic phasor estimates is expected to be small during swing and large after a fault, for detecting symmetrical fault detection during power swing. However, the dynamic phasor estimate, and sample reconstruction require significant computational capability.

As also described previously, a fault during power swing may go undetected when the impedance trajectory has crossed the blinders into one of the zones of operation due to swing (in case when implemented as per approaches described above). It is also important to note that the impedance calculations for a fault during power swing may not be reliable as phasor estimates during swing may tend to be poor. In such circumstances, a sustained fault may lead to high sustained currents through the transmission equipment (line, transformers, breakers, insulation, etc.) which is not desirable from the point of view of equipment health. It may also be the case that sustained faults may cause out-of-step/loss of synchronism condition as the angular separation between bus voltages widens. As would be evident from the prior approaches discussed in the preceding paragraphs, identification of a symmetrical fault during power swing is challenging. To this end, a dedicated mechanism is necessary for detection of faults during power swing when the relay is in blocked condition.

Approaches for detecting symmetric faults occurring during occurrence of a power swing condition are described. Once symmetric faults are detected, an unblock signal may be generated to release the block on an Intelligent Electronic Device (IED) to prevent damaging various components within the electrical network. In the present approaches, local measurements and their phasor estimates are utilized to detect occurrence of symmetrical fault. In one example, the detrended sum of phasor magnitudes of the three-phase electric supply are utilized for determining whether a symmetric fault has occurred. The approaches are computationally less extensive as compared to prior implementations, are fast and reliable.

To this end, measurements corresponding to each phase of a three-phase electric current are received. The measurements are obtained using a measurement device, such as a current transformer (CT) or a voltage transformer (VT) associated with a terminal of a power transmission line. During the monitoring, the measurements are sampled and for each sampling instant, a phasor magnitude for each phase of the three-phase electric current is calculated. In one example, about 20 samples may be obtained within each measurement window.

Once calculated, the phasor magnitudes is detrended to obtain a plurality of detrended phasor values. Based on the plurality of detrended phasor values, a value of a fault indicator is determined. The value of the fault indicator is then utilized for determining whether the symmetric fault in the power transmission line has occurred. To detect the occurrence of the symmetric fault, the fault indicator is compared with a reference value. Once the occurrence of the symmetric fault has been ascertained, an unblock signal may be generated to release the block on an IED.

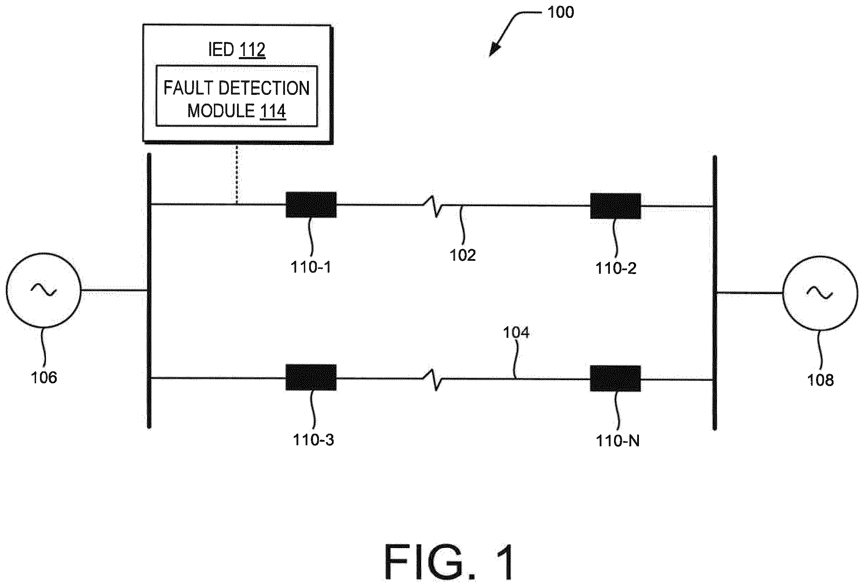

As would be understood, the present approaches enable detection of symmetric faults during the occurrence of a power swing condition. Furthermore, the present approaches are implemented periodically and within short time intervals, thereby limiting the computational time involved in determining whether symmetric faults have occurred during the power swing conditions. These and other aspects are further described in detail in conjunction with the accompanying FIGS. 1-5.

FIG. 1 provides a block diagram of a two-source equivalent electrical network 100, as per an example. The electrical network 100 comprises transmission lines 102, 104 and two-electrical sources, namely sources 106, 108. The transmission lines 102, 104 are further provided with one or more circuit breaker(s) 110-1, 2, 3, ..., N (collectively referred to as circuit breaker(s) 110). The circuit breaker(s) 110 allow opening of the circuit to restrict the flow of current in the electrical network. It may be noted that the electrical network 100 as depicted is only illustrative. The electrical network 100 may include further components without deviating from the scope of the present subject matter.

The electrical network 100 is further installed with an intelligent electronic device 112 (referred to as the IED 112). The IED 112 may be in electrical communication with the transmission lines 102, 104, either directly or through other connecting means. The IED 112, during operation, may receive and monitor measurements from one or more measurement devices. Examples of such measurement devices include, but are not limited to, current transformers and voltage transformers. Based on the measurements data received, the IED 112 may generate one or more signals to control the circuit breaker(s) 110, as explained in the following paragraphs.

The IED 112 further includes a fault detection module 114. The fault detection module 114 may be implemented as either software installed within the IED 112, or as hardware in the form of electronic circuitry integrated with the circuitry of the IED 112. The present example is described considering that the electrical network 100 is experiencing a power swing. As mentioned previously, disturbances in the steady-state of the electrical network 100 may result in the occurrence of a power swing, which may tend to vary otherwise stable parameters pertaining to the three-phase electric current. It may be possible that that such variations may occur due to symmetric faults. The present subject matter is capable of detecting symmetric faults that may occur during the power swing. It may be noted that the IED 112 may also be adapted to determine the occurrence of a power swing without deviating from the scope of the present subject matter.

In operation, the IED 112 may monitor a three-phase electric current within the electrical network 100. During the monitoring, the measurements corresponding to the three-phase electric current are sampled, and for each sampling instant a phasor magnitude for each phase of the three-phase electric current, is determined. In one example, a first set composed of a number of phasor magnitudes determined over a power cycle, is obtained. Once the first set is obtained, the IED 112 may select at least half the total number of phasor magnitudes from the first, which are in turn collected as a second set.

Once determined, the IED 112 may detrend the values of the second set of the phasor magnitudes. Based on the detrending, a set of detrended phasor magnitudes or values is obtained. It may be noted that the term detrended phasor magnitudes and detrended phasor values have been used interchangeably within the present description. Subsequently, the IED 112 may estimate value of a fault indicator. In one example, the fault indicator may be determined based on a sum of the detrended phasor magnitudes. Continuing with the present example, a norm of the sum of the detrended phasor magnitudes is determined by the IED 112 to obtain a normed sum of the detrended phasor magnitudes (also referred to as the NSDPM). The norm may be obtained by determining a 2-Norm of the detrended phasor magnitudes.

Once the fault indicator has been estimated by the IED 112, the fault detection module 114 compares the fault indicator corresponding to the detrended phasor magnitude with a predefined reference value. If the fault indicator is determined to be greater than the predefined reference value, the fault detection module 114 concludes that a symmetric fault has occurred. Conversely, if the fault indicator is less than the predefined reference value, the fault detection module 114 may conclude that variations in the electrical parameters of the transmission current are due to power swings within the electrical network. Based on its determination, the fault detection module 114 may provide a block release signal to unblock the IED 112. Other examples for detecting the occurrence of symmetric fault are further described in greater detail in conjunction with the other accompanying figures.

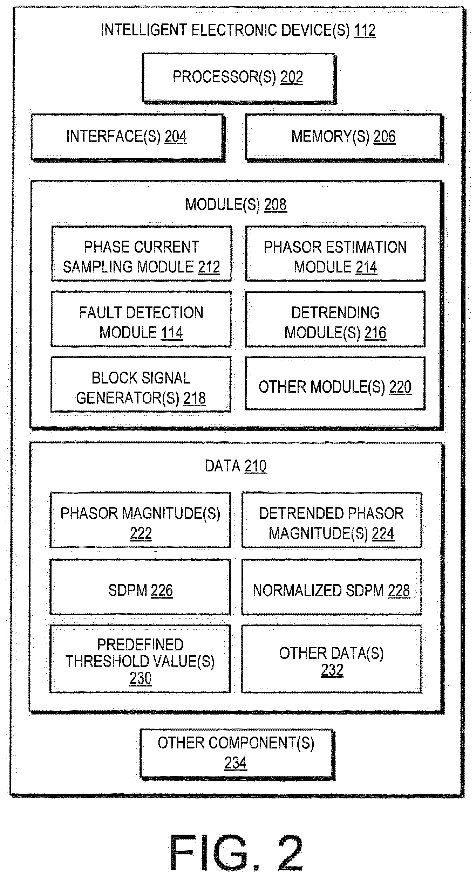

FIG. 2 provides a block diagram of an intelligent electronic device (IED) 112, as per one example. The IED 112 includes processor(s) 202 and a memory 206. The processor(s) 202 may be a single processing unit or may include a number of units, all of which could include multiple computing units. The processor(s) 202 may be implemented as one or more microprocessor, microcomputers, digital signal processors, central processing units, state machines, logic circuitries, and/or any devices that manipulate signals based on operational instructions. Among other capabilities the processor(s) 202 are adapted to fetch and execute processor-readable instructions stored in the memory 206 to implement one or more functionalities.

The interface(s) 204 may include a variety of software and hardware enabled interfaces. The interface(s) 204 may enable the communication and connectivity between the IED 112 and other components of the electrical network 100. Examples of such components include, but is not limited to, circuit breaker(s) 110 and sensors. The interface(s) 204 may facilitate multiple communications within a wide variety of protocols and may also enable communication with one or more computer enabled terminals or similar network components.

The memory 206 may be coupled to the processor(s) 202. The memory 206 may include any computer-readable medium known in the art including, for example, volatile memory, such as Static Random-Access Memory (SRAM) and Dynamic Random-Access Memory (DRAM), and/or non-volatile memory, such as Read Only Memory (ROM), Erasable Programmable ROMs (EPROMs), flash memories, hard disks, optical disks, and magnetic tapes.

The IED 112 may further one or more module(s) 208. The module(s) 208 may be implemented as a combination of hardware and programming (for example, programmable instructions) to implement a variety of functionalities of the module(s) 208. In examples described herein, such combinations of hardware and programming may be implemented in several different ways. For example, the programming for the module(s) 208 may be executable instructions. Such instructions in turn may be stored on a non-transitory machine-readable storage medium which may be coupled either directly with the IED 112 or indirectly (for example, through networked means). In case implemented as a hardware, the module(s) 208 may include a processing resource (for example, either a single processor or a combination of multiple processors), to execute such instructions. In the present examples, the processor-readable storage medium may store instructions that, when executed by the processing resource, implement module(s) 208. In other examples, module(s) 208 may be implemented by electronic circuitry.

The data 210 includes data that is either stored or generated as a result of functionalities implemented by any of the module(s) 208. In an example, the module(s) 208 include the fault detection module 114. In addition, the IED 112 may further include phase current sampling module 212, phasor estimation module 214, detrending module 216, block signal generator 218 and other module(s) 220. The other module(s) 220 may implement functionalities that supplement applications or functions performed by the IED 112 or any of the module(s) 208. The data 210 on the other hand may include phasor magnitude(s) 222, detrended phasor magnitude(s) 224, SDPM 226, normed SDPM 228 or NSDPM 228, predefined reference value 230 and other data 232. In addition, the IED 112 may further include other component(s) 234. Such other component(s) 234 may include a variety of other electrical components that enable functionalities of managing and controlling the operation of the electrical network 100. Examples of such other component(s) 234 include, but is not limited to, relays, controllers, switches and voltage regulators.

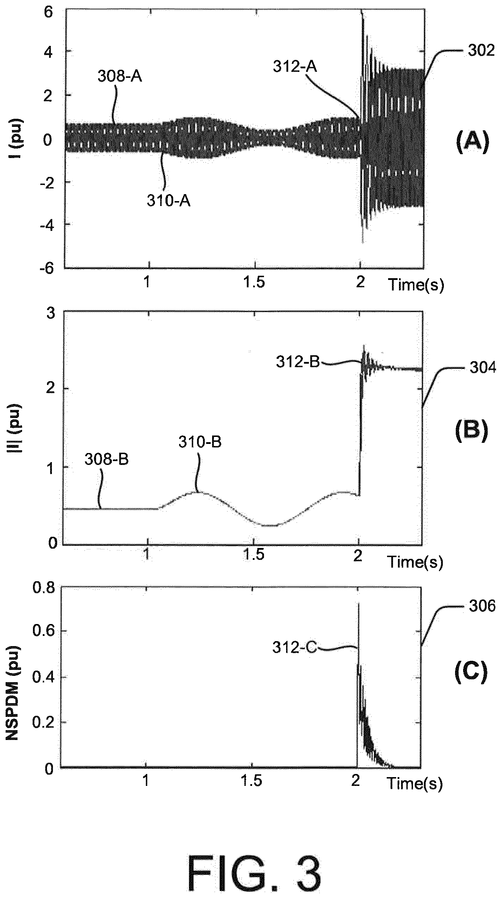

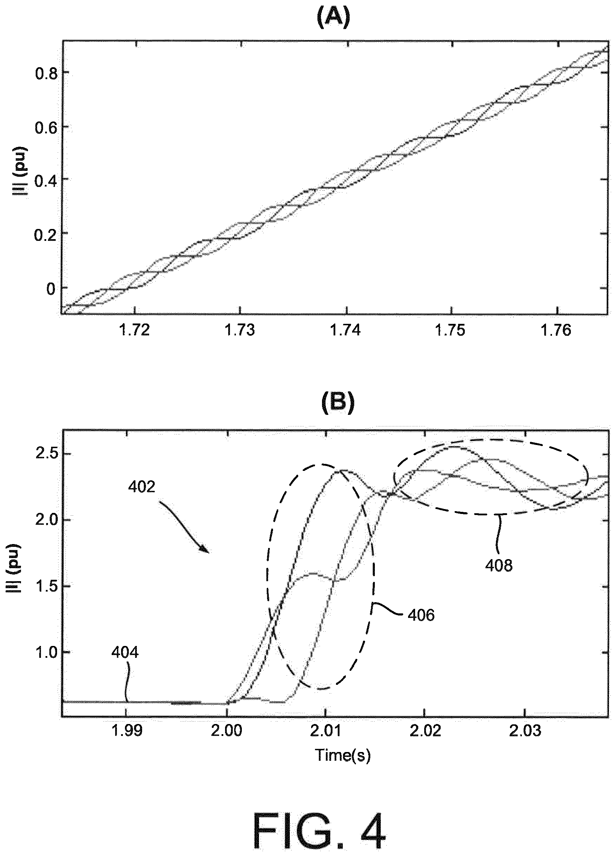

The IED 112 detects symmetric faults during the occurrence of power swing conditions within the electrical network, such as electrical network 100. The operation of the IED 112 is further described in conjunction with FIGS. 3-4. FIG. 3A-3C provides a series of illustrative graphs depicting the three-phase electric current waveforms, their corresponding phasor magnitudes and the variation in the normed sum of the detrended phasor magnitudes, i.e, the NSDPM 228. FIG. 4A-4B on the other hand, depicts variation in the phasor magnitudes of each phase of the three-phase electric current, during the occurrence of a symmetric fault.

The IED 112 may be connected with one or more measurement devices installed within the electrical network 100 through interface(s) 204. As mentioned previously, examples of such measurement devices include a current transformer or a voltage transformer. In operation, the phase current sampling module 212 monitors the current measurements corresponding to the three-phase electric current that is being transmitted within the electrical network 100. It may be noted that although the explanation is provided with respect current measurements, in a similar manner, voltage measurements may also be monitored without deviating from the scope of the present subject matter. Returning to present example, while monitoring, the phasor estimation module 214 (referred to as estimation module 214) determines phasor magnitudes corresponding for each phase of the three-phase electric current. In one example, the estimation module 214 is to determine the phasor magnitudes at multiple instants during a power cycle of the three-phase electric current. (Herein, the wordings "to", "is to" and the like may be understood in the sense that the module is configured to perform the corresponding function, and in particular that the module has respective hardware and software for performing the corresponding function). The phasor magnitudes determined by the estimation module 214 are then collectively stored in phasor magnitude(s) 222 as a first set. In one example, the first set of the phasor magnitude(s) 222 determined by the estimation module 214 is based on the following equation:

$$|I_p(k)| = |\sum_{n=k}^{k-N+1} i_p(n) e^{-\frac{j2\pi n}{N}}|$$

,

wherein:

$p$ is the phase of the three-phase electric current; and

$k$ is an index pertaining to window in which the three-phase electric current is sampled; and

N denotes the number of samples per cycle of the three-phase electric current. It may be noted that the above equation is only illustrative with the first set being determined through other mechanisms as well.

FIG. 3A is illustrative graphs depicting the three-phase electric current waveforms, as per one example, with FIG. 3B depicting the corresponding phasor magnitudes, such as the phasor magnitude(s) 222 as determined by the sampling module 212. In one example, the graph as depicted in FIG. 3A may be generated based on the current measurements received by the IED 112. It may also be noted that the graph thus depicted is only indicative and should be not be construed as a limitation. As would be observed, the three-phase electric current thus depicted is composed of three wave-forms, namely, wave-forms 308-A, 310-A and 312-A. The waveform 308-A depicts the three-phase electric current in an instance when electrical system (e.g., the electrical network 100) is in a steady state.

During the steady state condition depicted by wave-form 308-A, the variation of the current of each phase of the three-phase electric current is balanced, i.e., the maximum variation about zero value is constant. The corresponding section in FIG. 3B, as depicted by wave-form 308-B indicates that the phasor magnitudes of all phases of the three-phase electric current remains constant throughout the wave-form 308-B. It may also be noted that the present example is described with respect to three-phase electric current. Instead of three-phase electric current, a corresponding voltage signal may also be used and processed for detecting the occurrence of symmetric faults during power swing conditions, without deviating from the scope of the present subject matter.

The estimation module 214 may then select a number of phasor magnitudes from amongst the first set to obtain a second set of phasor magnitudes. For obtaining the second set, the estimation module 214 selects at least half of the number of the phasor magnitudes determined by the estimation module 214 for each phase. In another example, the estimation module 214 selects the phasor magnitudes which are obtained in the later part of the power cycle of the three-phase electric current. In yet another example, the second set of phasor magnitudes may be obtained based on the following equation (1):

$$\{|I_p|\}_k = \left[\ \left|I_p\left(k - \frac{N}{2} + 1\right)\right|, \left|I_p\left(k - \frac{N}{2}\right)\right|, \ldots, |I_p(k)|\right],$$

wherein

$p$ is the phase of the three-phase electric current; and

$k$ is an index pertaining to window in which the three-phase electric current is sampled, with N/2 recent phasor magnitudes being selected from the first set of phasor magnitude(s) 222.

Once obtained, the detrending module 216 detrends the second set of the phasor magnitudes to obtain the detrended phasor magnitude(s) 224. In one example, during a power swing condition in the electrical network, say the electrical network 100, three-phase electric current at any point of the power swing envelope (as illustrated) tends to have a monotonic variation with sinusoidal symmetry maintained across the phases. The monotonic variation may be that of increasing nature or decreasing depending upon the point in time of the swing envelope. FIG. 4A depicts the variation in the magnitudes of each phase of the three-phase electric current. As may be observed, the variation of each phase of the three-phase electric current is about a curve which is increasing. In certain cases, it has been observed that such a variation disappears when a symmetric fault occurs. In detrending the second set of phasor magnitudes, the detrending module 216 is to effectively separate the variations in the mean-values of the three-phase electric current and determine whether the current magnitudes, post such detrending depicts the presence of a symmetric fault. The detrending of the second set of phasor magnitudes may be represented through the following equation (2):

$$D\{|I_p|\}_k = detrended(\{|I_p|\}_k),$$

wherein

$p$ is the phase of the three-phase electric current, and $k$ is an index pertaining to window in which the three-phase electric current is sampled.

In one example, the detrending module 216 may implement the *'detrended'* function by determining a difference between the value of each of the phasor magnitudes from a value corresponding to a point lying on a curve representing the mean or the best-fit line corresponding to the phasor magnitudes of the second set. It may be noted that the detrending module 216 may detrend the second set based on any other mechanism or function without deviating from the scope of the present subject matter.

As would be noted the number of elements within the detrended phasor magnitude(s) 224 would correspond to the number of elements within the second set of the phasor magnitudes. Thereafter, the detrending module 216 may determine a sum of the detrended phasor magnitudes, which are subsequently stored within the IED 112 as SDPM. In one example, the SDPM 226 thus obtained may be an array of real values with the array having a dimension of [1xN/2]. In one example, the SDPM 226 may be represented by the following equation (3):

$$SDPM(k) = \sum\nolimits_{p=a,b,c} D\{|I_p|\}_k \quad \epsilon \quad R^{1X\frac{N}{2}},$$

wherein

$p$ is the phase of the three-phase electric current, with a, b, and c being each phase of the three-phase electric current, and $k$ is an index pertaining to window in which the three-phase electric current is sampled.

Once the sum of the detrended phasor magnitudes is obtained, the detrending module 216 may further determine the norm of the values within the SDPM 226. In one example, the detrending module 216 may obtain a norm of the values within SDPM 226 by obtaining the L2 norm of the values in the SDPM 226 as depicted through the following equation:

$$NSDPM(k) = [SDPM(k) \, X \, SDPM(k)^T]^{\frac{1}{2}},$$

wherein

$k$ is an index pertaining to window in which the three-phase electric current is sampled. It may be noted that any other mechanism for determining the norm of the SDPM 226 may also be employed without any limitation, with the normed SDPM being stored in the IED 112 as NSDPM 228. Such mechanisms would continue to fall within the scope of the present subject matter.

The NSDPM 228 may then be relied on as a fault indicator to determine whether a symmetric fault has occurred during a power swing. In one example, the fault detection module 114 determines the occurrence of a symmetric fault based on the comparison of the NSDPM 228 and a predefined reference value 230. If the NSDPM 228 is less than the predefined reference value 230 (referred to as the value 230), the fault detection module 114 may determine that any variations in the three-phase electric current may be due to power swing conditions in the electrical network 100. On the other hand, if the NSDPM is greater than the value 230, the fault detection module 114 may conclude that a symmetric fault has occurred within the electrical network 100. In one example, the value 230 may be selected based on the desired sensitivity for detecting the occurrence of symmetric faults. In one example, the value 230 may be selected from a range of about 0.03 to about 0.1.

The waveforms pertaining to the three-phase electric current and its corresponding phasor magnitudes during a power swing and a symmetric fault are depicted as sections 310-A and 310-B, respectively. As may be observed, the three-phase electric current is subject to oscillations, with the phasor magnitudes clearly undergoing a sinusoidal variation. The sections 312-A and 312-B depict the instances when a symmetric fault has occurred within the electrical network. As may be observed, the variations in the three-phase electric current (depicted by section 312-A) and the change in the phasor magnitudes (depicted by section 312-B) vary drastically when considered with the respect to the variations during the power swing (i.e., depicted by section 310-A and 310-B). FIG. 3C depicts the variation 312-C, which is the normed sum of the detrended phasor magnitudes. As may be observed, the portion of the variation 312-C is zero till the occurrence of the symmetric fault within the electrical network. The variation 312-C increases as the symmetric fault occurs. This sudden increase in the value of the normed sum of the detrended phasor magnitudes is utilized for ascertaining the presence of a symmetric fault.

FIG. 4B illustrates a graphical representation 402 of a phasor current magnitude during occurrence of a three-phase fault, in accordance with one implementation of the present subject matter. The graphical representation 402 includes a first portion 404 and a second portion 406. The graphical representation 402 shown is within a time duration of about 1.98 seconds to about 2.04 seconds. The first portion 404 may be within a time duration of about 1.98 seconds to about 2 seconds. The second portion 406 may be within a time interval of about 20 milliseconds. The third portion 408 may be within a time duration of about 2.02 seconds to about 2.04 seconds.

During the first portion 404, a power swing condition is occurring and in which the three phase currents oscillates at a swing-modulated frequency. During the second portion 406 (i.e., within the fault window between 1.99 s - 2.03 s), a transient post-fault is present. As is evident in FIG. 4A during the power swing condition, there are two aspects to the phasor magnitude estimates. Firstly, there is a monotonic trend, which is representative of the rising magnitudes of the currents due to swing (as depicted in FIG. 4A). Secondly, the amplitude estimates across the three phases have an oscillatory behavior with three phase sinusoidal symmetry. In one example, the oscillatory nature of the amplitudes may be an estimation error which is attributable to the frequency response of the estimation filters which try to fit the modulated waveforms during swing to a fundamental phasor rotating at nominal (50 Hz in this case) electrical frequency. However, after the fault, this behavior is lost due to the transients in the current waveform

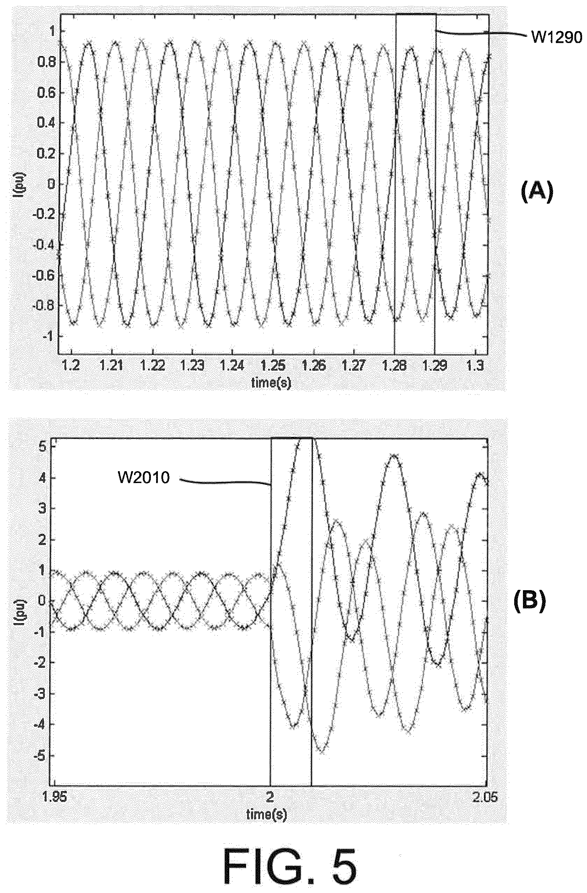

The above variations are further explained in conjunction with FIGS 5-7 to depict the variations in the example windows labelled as W1290 and W2010. These are to be considered with the illustrative graphs depicted in the preceding figures. As mentioned previously, FIG. 3A depicts the three-phase current waveforms when the system undergoes power swing (waveform 308-A) from steady state condition and then a three-phase fault occurs during the swing (waveform 310-A). FIG. 5 provides a magnified view to depict granular variations which may not be discernible from FIG. 3A. FIG. 5A provides a magnified view of 5-cycle zoom-in into a swing timeframe, while FIG. 5B is a 5-cycle zoom-in into a "fault-during-a-swing" timeframe within the time window W1290. As would be understood, a reference to the term 'cycle' may be considered, only for the present example, 20 ms of time with the fundamental frequency of the current sine waves being 50 Hz. In each of these time frames, the FIGS 5A-5B represent on an analysis "window" of half cycle length, i.e., 10 ms. In the FIGS. 5-7, the swing timeframe has been considered to be the time spanning from 1.281 s - 1.290 s (labelled as W1290), while for the fault occurring during power swing, the time period considered is 2.001 s - 2.010 s (labelled as W2010). Although these specific time references have been considered, these should not be construed to limit the scope of the claimed subject matter in any manner.

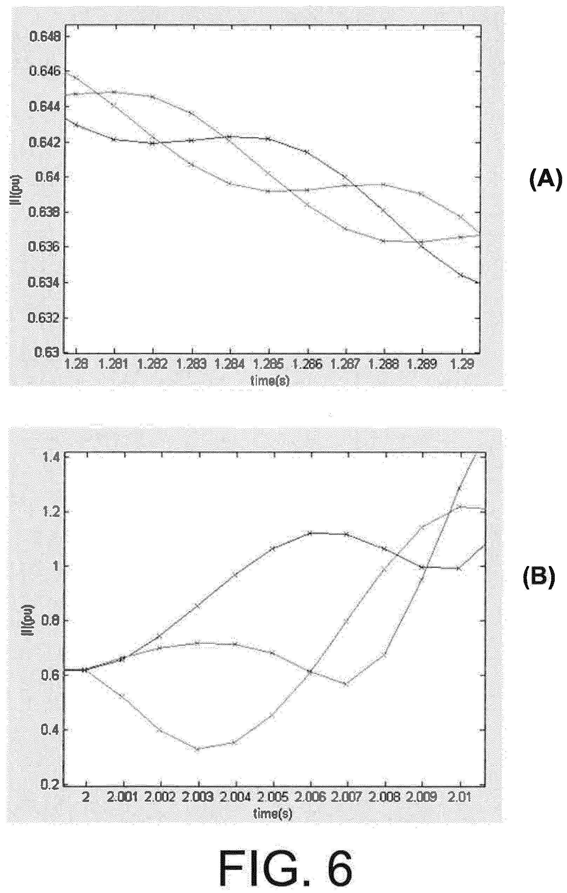

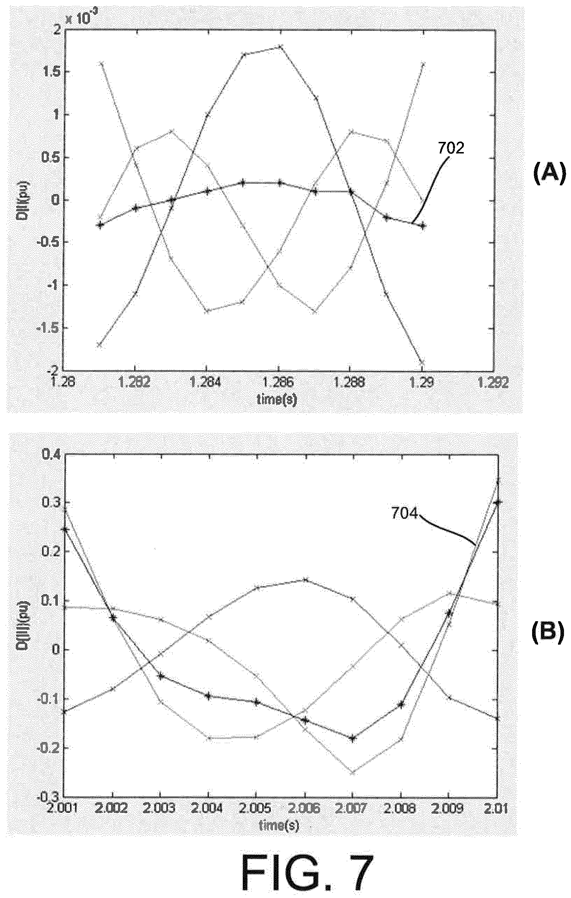

Returning to the present example, FIGS. 6A-6B depict the phasor magnitudes computed in the windows W1290 and W2010 respectively by using phasor estimation mechanisms as described in the context of phasor estimation module 214. The corresponding values are shown in the first three columns of Table 1 and Table 2, respectively, depicted in the paragraphs that follow. As would be understood for a window, each of these columns consists of 10 values which correspond to the set $\{|I_p|\}(p = a, b, c)$ as depicted in equation (1). Columns 4-6 of the aforementioned tables depict the values of the phasor magnitudes after they have been detrended as per equation (2). In one example, the values exemplified in column 4 are obtained by applying detrending operation on Column 1, so on and so forth. The same are plotted in FIG. 7A-7B in which each of the curves represent the detrended phasor magnitudes. Column 7 in each of these tables shows the Sum of Detrended Phasor Magnitudes or SDPM 226 obtained by adding up the corresponding entries in columns 4, 5 and 6 as per equation (3). The values of SDPM 226 are depicted in FIG. 7A-7B with the curve 702, 704. Finally, we obtain the scalar index Norm of SDPM or NSDPM by taking the 2-Norm of SDPM (i.e. column 7) as per equation (5). For W1290 its value is -0.00054 while for W2010 it is -0.5. It is to be noted that the present example is one of the many examples which fall within the scope of the present subject matter. Other examples are also possible and such examples would continue to remain within the scope of the present subject matter, without any limitation.

Table 1

| {|Ia|} | {|Ib|} | {|Ic|} | D{|Ia|} | D{|Ib|} | D{|Ic|} | SDPM |
|---|---|---|---|---|---|---|
| 0.6421 | 0.6448 | 0.6441 | -0.0017 | -0.0002 | 0.0016 | -0.0003 |
| 0.6419 | 0.6445 | 0.6423 | -0.0011 | 0.0006 | 0.0004 | -0.0001 |
| 0.6421 | 0.6436 | 0.6407 | -0.0001 | 0.0008 | -0.0007 | 0 |
| 0.6423 | 0.6421 | 0.6396 | 0.001 | 0.0004 | -0.0013 | 0.0001 |
| 0.6422 | 0.6402 | 0.6392 | 0.0017 | -0.0003 | -0.0012 | 0.0002 |
| 0.6414 | 0.6384 | 0.6393 | 0.0018 | -0.001 | -0.0006 | 0.0002 |
| 0.64 | 0.6371 | 0.6395 | 0.0012 | -0.0013 | 0.0002 | 0.0001 |
| 0.6381 | 0.6364 | 0.6396 | 0.0001 | -0.0008 | 0.0008 | 0.0001 |
| 0.6361 | 0.6363 | 0.639 | -0.0011 | 0.0002 | 0.0007 | -0.0002 |
| 0.6345 | 0.6366 | 0.6377 | -0.0019 | 0.0016 | 0 | -0.0003 |
|  |  |  |  |  |  | NSDPM= 0.000583 |

Table 2

| {|Ia|} | {|Ib|} | {|Ic|} | D{|Ia|} | D{|Ib|} | D{|Ic|} | SDPM |
|---|---|---|---|---|---|---|
| 0.6584 | 0.6652 | 0.5235 | -0.1264 | 0.0866 | 0.2856 | 0.2458 |
| 0.743 | 0.7019 | 0.3991 | -0.0805 | 0.0833 | 0.0625 | 0.0653 |
| 0.8533 | 0.7204 | 0.3292 | -0.0088 | 0.0616 | -0.1061 | -0.0533 |
| 0.9682 | 0.7168 | 0.3538 | 0.0674 | 0.0179 | -0.1803 | -0.095 |
| 1.0655 | 0.6847 | 0.4536 | 0.126 | -0.0542 | -0.1791 | -0.1073 |
| 1.1214 | 0.6166 | 0.6081 | 0.1432 | -0.1624 | -0.1233 | -0.1425 |
| 1.1203 | 0.5686 | 0.7971 | 0.1035 | -0.2505 | -0.0331 | -0.1801 |
| 1.0663 | 0.676 | 0.9913 | 0.0108 | -0.1832 | 0.0625 | -0.1099 |
| 0.9981 | 0.953 | 1.1449 | -0.0961 | 0.0537 | 0.1174 | 0.075 |
| 0.9937 | 1.2865 | 1.2202 | -0.1391 | 0.3471 | 0.094 | 0.302 |
| | | | | | | NSDPM= 0.4997 |

Depending on the determination of the fault detection module 114, the block signal generator 218 may be activated. For example, in the event of the fault detection module 114 determining that no symmetric fault as occurred, the IED 112 may be allowed to operate wherein the IED 112 will block tripping of the circuit breaker(s) 110 within the electrical network 100. On the other hand, if the fault detection module 114 detects the occurrence of a symmetric fault within the electrical network 100, the block signal generator 218 generate an unblock signal to release the block on the IED 112. Once the block on the IED 112 is released, the IED 112 will trip the circuit breaker(s) 110 to isolate the electric components from the prevailing faults. Although the present example has been described in the context of circuit breaker(s) 110, it may be noted that the block signal generator 218 may also generate one or more signals for controlling the operation of other electrical components within the electrical network 100 for isolating one or more components, if a symmetric fault occurs.

FIG. 5 illustrates a flowchart of a method 500 for detecting a symmetric fault, in accordance with one implementation of the present subject matter. The order in which the methods are described is not intended to be construed as a limitation, and any number of the described method blocks may be combined in any order to implement the methods, or an alternative method. Furthermore, method 500 may be implemented by processing resource through any suitable hardware, non-transitory machine-readable instructions, or combination thereof.

At block 802, a first set of phasor magnitudes of a three-phase electric current are determined. For example, the phase current sampling module 212 of the IED 112 obtains a first set based on the current measurements corresponding to the three-phase electric current, received by the IED 112. The first set includes a plurality of phasor magnitudes of a three-phase electric current. The phasor magnitudes are determined over a power cycle of the three-phase electric current.

At block 804, a second set of phasor magnitudes of the three-phase electric current are determined. For example, the phase current sampling module 212 of the IED 112 obtains a second set. The second set includes at least half of the number of phasor magnitudes for each phase, amongst the first set. The second set includes a predefined number (ex. N/2) recent phasor magnitude estimates for each phase of the three-phase electric current. The first set and second set as obtained may then be stored in the phasor magnitude(s) 222 of the data 210 of the IED 112.

At block 806, the second set of phasor magnitudes are detrended to obtain a set of detrended phasor magnitudes. For example, the detrending module 216 of the IED 112 obtains a set of detrended phasor magnitudes. The set of detrended phasor magnitudes may be obtained, for example, by subtracting the mean or best fit line corresponding to the values of the second set.

At block 808, the elements of the set of detrended phasor magnitudes are summed to obtain a sum of detrended phasor magnitudes. For example, the detrending module 216 of the IED 112 sums elements of the set of detrended phasor magnitudes to obtain a sum of detrended phasor magnitudes, i.e., SDPM 226.

At block 810, a norm based on the sum of the detrended phasor magnitudes is obtained to provide a normed sum of the detrended phasor magnitudes (referred to as the NSDPM). For example, the fault detection module 114 of the IED 112 determines the norm of the SDPM 226 obtained at block 508, to obtain the normed sum of the detrended phasor magnitudes (NSDPM 228). The normed detrended phasor magnitudes is obtained when the sum of detrended phasor magnitudes obtained at block 508 is semi normed or 2-normed. The normed sum of the detrended phasor magnitudes obtained may be stored as NSDPM 228 in the data 210 of the IED 112.

At block 812, an occurrence of a symmetric fault is detected. For example, the fault detection module 114 detects the occurrence of the symmetric fault within the electrical network. To that end, the fault detection module 114 compares the normed sum of the detrended phasor magnitudes (i.e., the NSDPM 228) with the predefined reference value 230. This comparison determines whether the intelligent electronic device 112 is to be unblocked upon detection of the symmetric fault. In an example, the predefined reference value 230 may be within a range of about 0.03 to 0.1.

At block 814, the intelligent electronic device may be unblocked in case a symmetric fault has occurred. For example, if the fault detection module 114 detects the occurrence of a symmetric fault within the electrical network 100, the block signal generator 218 generate a signal to release the block on the IED 112. As a result, the IED 112 will trip the circuit breaker(s) 110 to trip and isolate the electric components from the prevailing faults.

## Claims

1. A method for detecting a symmetric fault during a power swing condition in a power transmission system connecting at least two terminals with one or more power transmission lines (102, 104), the method comprising:

   receiving measurements corresponding to each phase of one of a three-phase electric current or a three-phase electric voltage, wherein the measurements are obtained using measurement equipment associated with a terminal of a power transmission line (102, 104) of the power transmission system, in a measurement window of one-cycle length;
   calculating, phasor magnitudes for a plurality of samples in each measurement window for the measurements for each phase;
   calculating a detrended phasor value for each phasor magnitude by detrending the phasor magnitudes calculated for the plurality of samples, to obtain a plurality of detrended phasor values for each phase, wherein said detrending effectively separates variations in mean values of phasor magnitudes;
   estimating a value of a fault indicator for the measurement window, based on the plurality of detrended phasor values calculated for the three phases for the measurement window;
   detecting occurrence of a symmetric fault in the power transmission line (102, 104) monitored with the measurement equipment, based on comparison of the value of the fault indicator with a predefined reference value; and
   generating an unblock signal in response to the detection of the symmetric fault during the power swing condition, for protecting the power transmission line in response the symmetric fault.

2. The method as claimed in claim 1, wherein calculating the detrended phasor values for each measurement window comprises:

   selecting the phasor magnitudes, wherein the phasor magnitudes are half a plurality of phasor magnitudes corresponding to the plurality of samples within the measurement window; and
   calculating the detrended phasor value for the phasor magnitudes for the selected phasor magnitudes to provide the detrended phasor values.

3. The method as claimed in claim 2, wherein estimating the value of the fault indicator comprises summing the plurality of detrended phasor values obtained for each of the phases of one of the three-phase electric current and the three-phase electric voltage.

4. The method as claimed in claim 3, wherein the summing comprises:

   summing for each sample the detrended phasor value in the three phases to obtain a plurality of summed detrended phasor values; and
   obtaining a norm of the summed detrended phasor values to estimate the value of the fault indicator.

5. The method as claimed in claim 1, wherein the plurality of phasor magnitudes corresponding to the plurality of samples within the measurement window is determined based on the following equation:

$$|I_p(k)| = |\sum_{n=k}^{k-N+1} i_p(n)e^{-\frac{j2\pi n}{N}}|$$

,

wherein:

p is the phase of the three-phase electric current; and
k is an index pertaining to window in which the three-phase electric current is sampled.

6. The method as claimed in claim 4, wherein norm of the summed detrended phasor values is based on the following equation:

$$NSDPM(k) = [SDPM(k) \, X \, SDPM(k)^T]^{\frac{1}{2}}$$

wherein

NSDPM represents the norm of SDPM; and
wherein SDPM denotes the summed detrended phasor values.

7. An intelligent electronic device, IED, (112) to detect a symmetric fault within an electrical network (100), with the IED being provided at one end of a power transmission line (102) connecting at least two terminals with one or more power transmission line, the IED comprising:

a microprocessor (201);
an output interface (234):

a phase current sampling module (212) to:
obtain measurements corresponding to each phase of a three-phase electric current, wherein the current measurements are obtained using measurement equipment associated with a terminal of a power transmission line of the power transmission system, in a measurement window of one-cycle length;
a phasor estimation module to:
calculate phasor magnitudes for a plurality of samples in each measurement window for the measurements for each phase of the three-phase electric current;
a detrending module configured to:
calculate a detrended phasor value for each current phasor magnitude by detrending the current phasor magnitudes calculated for the plurality of samples, to obtain a plurality of detrended phasor values for each phase of the three-phase electric current, wherein said detrending effectively separates variations in mean values of phasor magnitudes;

a fault detection module coupled to the output interface, wherein the fault detection module is configured to:

estimate a value of a fault indicator for the measurement window, based on the plurality of detrended phasor values calculated for the three phases for the measurement window;
detect occurrence of a symmetric fault in the power transmission line monitored with the measurement equipment, based on comparison of the value of a fault indicator with a predefined reference value; and
generate an unblock signal in response to the detection of the symmetric fault during the power swing condition, for protecting the power transmission line in response the symmetric fault, wherein the unblock signal is transmitted via the output interface.

8. The IED as claimed in claim 7, wherein to calculate the calculate phasor magnitudes for the plurality of samples, the detrending module is configured to:

select half a plurality of current phasor magnitudes corresponding to the plurality of samples within the measurement window to provide the current phasor magnitudes; and
calculate the detrended phasor values based on the selected current phasor magnitudes, wherein the detrended phasor values are calculated by subtracting the mean or best fit line corresponding to the selected current phasor magnitudes.

9. The IED as claimed in claim 7, wherein the fault detection module to estimate the value of the fault indicator, is configured to:

determine a sum of the plurality of detrended phasor values obtained for phases of the three-phase electric current by summing for each sample the detrended phasor value in the three phases to obtain a plurality of summed detrended phasor values; and

obtain a norm of the summed detrended phasor values to estimate the value of the fault indicator, wherein norm of the summed detrended phasor values is based on the following equation:

$$NSDPM(k) = [SDPM(k) \, X \, SDPM(k)^T]^{\frac{1}{2}}$$

wherein

NSDPM is the value of the fault indicator and represents the norm of SDPM; and
wherein SDPM denotes the summed detrended phasor values.

10. The IED as claimed in claim 7, wherein the value of a fault indicator lies between a range of about 0.03 to about 0.1.


**Patentansprüche**

1. Verfahren zum Erkennen eines symmetrischen Fehlers während eines Leistungspendelzustands in einem Stromübertragungssystem, das mindestens zwei Endgeräte mit einer oder mehreren Stromübertragungsleitungen (102, 104) verbindet, wobei das Verfahren umfasst:

Empfangen von Messungen, die jeder Phase eines dreiphasigen elektrischen Stroms oder einer dreiphasigen elektrischen Spannung entsprechen, wobei die Messungen unter Verwendung von Messgeräten, die einem Endgerät einer Stromübertragungsleitung (102, 104) des Stromübertragungssystems zugeordnet sind, in einem Messfenster von einer Zykluslänge erhalten werden;
Berechnen der Phasorgrößen für eine Mehrzahl von Proben in jedem Messfenster für die Messungen für jede Phase;
Berechnen eines trendbereinigten Phasorwerts für jede Phasorgröße durch Trendbereinigen der für die Mehrzahl von Proben berechneten Phasorgrößen, um eine Mehrzahl von trendbereinigten Phasorwerten für jede Phase zu erhalten, wobei das Trendbereinigen effektiv Variationen in Mittelwerte der Phasorgrößen trennt;
Schätzen eines Wertes eines Fehlerindikators für das Messfenster, basierend auf der Mehrzahl von trendbereinigten Phasorwerten, die für die drei Phasen für das Messfenster berechnet wurden;
Erkennen des Vorkommens eines symmetrischen Fehlers in der mit dem Messgerät überwachten Stromübertragungsleitung (102, 104), basierend auf dem Vergleich des Wertes des Fehlerindikators mit einem vordefinierten Referenzwert; und
Erzeugen eines Entsperrsignals als Reaktion auf die Erkennung des symmetrischen Fehlers während des Leistungspendelzustands, um die Stromübertragungsleitung als Reaktion auf den symmetrischen Fehler zu schützen.

2. Verfahren nach Anspruch 1, wobei das Berechnen der trendbereinigten Phasorwerte für jedes Messfenster umfasst:

Auswählen der Phasorgrößen, wobei die Phasorgrößen die Hälfte einer Mehrzahl von Phasorgrößen sind, die der Mehrzahl von Proben innerhalb des Messfensters entsprechen; und
Berechnen des trendbereinigten Phasorwertes für die Phasorgrößen für die ausgewählten Phasorgrößen, um die trendbereinigten Phasorwerte bereitzustellen.

3. Verfahren nach Anspruch 2, wobei das Schätzen des Wertes des Fehlerindikators das Summieren der Mehrzahl der trendbereinigten Phasorwerte umfasst, die für jede der Phasen des dreiphasigen elektrischen Drehstroms oder der dreiphasigen elektrischen Drehspannung erhalten wurden.

4. Verfahren nach Anspruch 3, wobei das Summieren umfasst:

Summieren des trendbereinigten Phasorwerts in den drei Phasen für jede Probe, um eine Mehrzahl von summierten trendbereinigten Phasorwerten zu erhalten; und
Erhalten einer Norm der summierten trendbereinigten Phasorwerte, um den Wert des Fehlerindikators zu schätzen.

5. Verfahren nach Anspruch 1, wobei die Mehrzahl von Phasorgrößen, die der Mehrzahl von Proben innerhalb des Messfensters entsprechen, basierend auf der folgenden Gleichung bestimmt wird:

$$|I_p(k)| = |\sum_{n=k}^{k-N+1} i_p(n)e^{-\frac{j2\pi n}{N}}|,$$

wobei:

p die Phase des dreiphasigen elektrischen Stroms ist; *und*
k ein Index ist, der sich auf das Fenster bezieht, in dem der dreiphasige elektrische Strom abgetastet wird.

6. Verfahren nach Anspruch 4, wobei die Norm der summierten trendbereinigten Phasorwerte auf der folgenden Gleichung basiert:

$$NSDPM(k) = [SDPM(k) \, X \, SDPM(k)^T]^{\frac{1}{2}},$$

wobei

*NSDPM* die Norm der SDPM repräsentiert; und
wobei *SDPM* die summierten trendbereinigten Phasorwerte bezeichnet.

7. Intelligente elektronische Vorrichtung, IED, (112) um einen symmetrischen Fehler innerhalb eines elektrischen Netzwerks (100) zu erkennen, wobei die IED an einem Ende einer Stromübertragungsleitung (102) bereitgestellt wird, die zumindest zwei Endgeräte mit einer oder mehreren Stromübertragungsleitungen verbindet, wobei die IED aufweist:

einen Mikroprozessor (201);
eine Ausgabeschnittstelle (234):
ein Phasenstrom-Abtastmodul (212), um:

Messungen zu erhalten, die jeder Phase eines dreiphasigen elektrischen Stroms entsprechen, wobei die Strommessungen unter Verwendung von Messgeräten, die einem Endgerät einer Stromübertragungsleitung des Stromübertragungssystems zugeordnet sind, in einem Messfenster von einer Zykluslänge erhalten werden;
ein Modul zur Phasor-Schätzung, um:

Phasorgrößen für eine Mehrzahl von Proben in jedem Messfenster für die Messungen für jede Phase des elektrischen Dreiphasenstroms zu berechnen;
ein trendbereinigtes Modul, das dazu ausgelegt ist:

einen trendbereinigten Phasorwert für jede Strom-Phasorgröße durch Trendbereinigen der für die Mehrzahl der Proben berechneten Strom-Phasorgrößen zu berechnen, um eine Mehrzahl von trendbereinigten Phasorwerten für jede Phase des dreiphasigen elektrischen Stroms zu erhalten, wobei das Trendbereinigen effektiv Variationen in Mittelwerte der Phasorgrößen trennt;
ein mit der Ausgabeschnittstelle gekoppeltes Fehlererkennungsmodul, wobei das Fehlererkennungsmodul dazu ausgelegt ist:

einen Wert eines Fehlerindikators für das Messfenster basierend auf der Mehrzahl von trendbereinigten Phasorwerten zu schätzen, die für die drei Phasen für das Messfenster berechnet wurden;
das Vorkommen eines symmetrischen Fehlers in der mit dem Messgerät überwachten Stromübertragungsleitung basierend auf dem Vergleich des Wertes des Fehlerindikators mit einem vordefinierten Referenzwert zu erkennen; und

als Reaktion auf die Erkennung des symmetrischen Fehlers während des Leistungspendelzustands ein Entsperrsignal zum Schützen der Stromübertragungsleitung als Reaktion auf den symmetrischen Fehler zu erzeugen, wobei das Entsperrsignal über die Ausgabeschnittstelle übertragen wird.

**8.** IED nach Anspruch 7, wobei, um die berechneten Phasorgrößen für die Mehrzahl der Proben zu berechnen, das Trendbereinigungsmodul dazu ausgelegt ist:

die Hälfte einer Mehrzahl von Strom-Phasorgrößen auszuwählen, die der Mehrzahl von Proben innerhalb des Messfensters entsprechen, um die Strom-Phasorgrößen bereitzustellen; und
die trendbereinigten Phasorwerte basierend auf den ausgewählten Strom-Phasorgrößen zu berechnen, wobei die trendbereinigten Phasorwerte durch Subtrahieren des Mittelwerts oder der Linie mit der besten Anpassung entsprechend den ausgewählten Strom-Phasorgrößen berechnet werden.

**9.** IED nach Anspruch 7, wobei das Fehlererkennungsmodul, um den Wert des Fehlerindikators zu schätzen, dazu ausgelegt ist:

eine Summe der Mehrzahl von trendbereinigten Phasorwerten zu bestimmen, die für Phasen des dreiphasigen elektrischen Stroms durch Summieren des trendbereinigten Phasorwerts in den drei Phasen für jede Probe erhalten werden, um eine Mehrzahl von summierten trendbereinigten Phasorwerten zu erhalten; und
eine Norm der summierten trendbereinigten Phasorwerte zu erhalten, um den Wert des Fehlerindikators zu schätzen, wobei die Norm der summierten trendbereinigten Phasorwerte auf der folgenden Gleichung basiert:

$$NSDPM(k) = [SDPM(k) \, X \, SDPM(k)^T]^{\frac{1}{2}},$$

wobei
*NSDPM* der Wert des Fehlerindikators ist und die Norm der SDPM repräsentiert; und
wobei *SDPM* die summierten trendbereinigten Phasorwerte bezeichnet.

**10.** IED nach Anspruch 7, wobei der Wert eines Fehlerindikators in einem Bereich zwischen etwa 0,03 und etwa 0,1 liegt.

**Revendications**

**1.** Procédé de détection d'un défaut symétrique pendant une condition d'oscillation de puissance dans un système de transmission de puissance connectant au moins deux bornes avec une ou plusieurs lignes de transmission de puissance (102, 104), le procédé comprenant :

la réception de mesures correspondant à chaque phase d'un courant électrique triphasé ou d'une tension électrique triphasée, les mesures étant obtenues en utilisant un équipement de mesure associé à une borne d'une ligne de transmission de puissance (102, 104) du système de transmission de puissance, dans une fenêtre de mesure d'une longueur d'un cycle ;
le calcul, de grandeurs de phaseurs pour une pluralité d'échantillons dans chaque fenêtre de mesure pour les mesures pour chaque phase ;
le calcul d'une valeur de phaseur à tendance éliminée pour chaque grandeur de phaseur en éliminant la tendance des grandeurs de phaseurs calculées pour la pluralité d'échantillons, pour obtenir une pluralité de valeurs de phaseurs à tendances éliminées pour chaque phase, ladite élimination de tendance séparant efficacement des variations dans des valeurs moyennes de grandeurs de phaseur ;
l'estimation d'une valeur d'un indicateur de défaut pour la fenêtre de mesure, sur la base de la pluralité de valeurs de phaseurs à tendances éliminées calculées pour les trois phases pour la fenêtre de mesure ;
la détection de la survenue d'un défaut symétrique dans la ligne de transmission de puissance (102, 104) surveillée avec l'équipement de mesure, sur la base d'une comparaison de la valeur de l'indicateur de défaut avec une valeur de référence prédéfinie ; et
la génération d'un signal de déblocage en réponse à la détection du défaut symétrique pendant la condition d'oscillation de puissance, pour protéger la ligne de transmission de puissance en réponse au défaut symétrique.

2. Procédé selon la revendication 1, le calcul des valeurs de phaseurs à tendances éliminées pour chaque fenêtre de mesure comprenant :

la sélection des grandeurs de phaseurs, les grandeurs de phaseurs étant une moitié d'une pluralité de grandeurs de phaseurs correspondant à la pluralité d'échantillons dans la fenêtre de mesure ; et
le calcul de la valeur de phaseur à tendance éliminée pour les grandeurs de phaseurs pour les grandeurs de phaseurs sélectionnées afin de fournir les valeurs de phaseurs à tendances éliminées.

3. Procédé selon la revendication 2, l'estimation de la valeur de l'indicateur de défaut comprenant la sommation de la pluralité de valeurs de phaseurs à tendances éliminées obtenues pour chacune des phases du courant électrique triphasé ou de la tension électrique triphasée.

4. Procédé selon la revendication 3, la sommation comprenant :

la sommation pour chaque échantillon de la valeur de phaseur à tendance éliminée dans les trois phases afin d'obtenir une pluralité de valeurs de phaseurs à tendances éliminées sommées ; et
l'obtention d'une norme des valeurs de phaseurs à tendances éliminées sommées pour estimer la valeur de l'indicateur de défaut.

5. Procédé selon la revendication 1, la pluralité de grandeurs de phaseurs correspondant à la pluralité d'échantillons dans la fenêtre de mesure étant déterminée sur la base de l'équation suivante :

$$|I_p(k)| = |\sum_{n=k}^{k-N+1} i_p(n)e^{-\frac{j2\pi n}{N}}|,$$

dans laquelle :

$p$ est la phase du courant électrique triphasé ; et
$k$ est un indice relatif à la fenêtre dans laquelle le courant électrique triphasé est échantillonné.

6. Procédé selon la revendication 4, une norme des valeurs de phaseurs à tendances éliminées sommées étant basée sur l'équation suivante :

$$NSDPM(k) = [SDPM(k) \, X \, SDPM(k)^T]^{\frac{1}{2}},$$

dans laquelle

$NSDPM$ représente la norme des SDPM ; et
dans laquelle $SDPM$ désigne les valeurs de phaseurs à tendances éliminées sommées.

7. Dispositif électronique intelligent, IED, (112) destiné à détecter un défaut symétrique dans un réseau électrique (100), avec l'IED étant prévu au niveau d'une extrémité d'une ligne de transmission de puissance (102) connectant au moins deux bornes avec une ou plusieurs lignes de transmission de puissance, l'IED comprenant :

un microprocesseur (201) ;
une interface de sortie (234) ;
un module d'échantillonnage de courant de phase (212) pour :

obtenir des mesures correspondant à chaque phase d'un courant électrique triphasé, les mesures de courant étant obtenues en utilisant un équipement de mesure associé à une borne d'une ligne de transmission de puissance du système de transmission de puissance, dans une fenêtre de mesure d'une longueur d'un cycle ;
un module d'estimation de phaseur pour :

calculer des grandeurs de phaseurs pour une pluralité d'échantillons dans chaque fenêtre de mesure pour les mesures pour chaque phase du courant électrique triphasé ;
un module d'élimination de tendance configuré pour :

calculer une valeur de phaseur à tendance éliminée pour chaque grandeur de phaseur de courant en éliminant la tendance des grandeurs de phaseurs de courant calculées pour la pluralité d'échantillons, pour obtenir une pluralité de valeurs de phaseurs à tendances éliminées pour chaque phase du courant électrique triphasé, ladite élimination de tendance séparant efficacement des variations dans des valeurs moyennes de grandeurs de phaseur ;
un module de détection de défaut couplé à l'interface de sortie, le module de détection de défaut étant configuré pour :

estimer une valeur d'un indicateur de défaut pour la fenêtre de mesure, sur la base de la pluralité de valeurs de phaseurs à tendances éliminées calculées pour les trois phases pour la fenêtre de mesure ;
détecter la survenue d'un défaut symétrique dans la ligne de transmission de puissance surveillée avec l'équipement de mesure, sur la base d'une comparaison de la valeur d'un indicateur de défaut avec une valeur de référence prédéfinie ; et
générer un signal de déblocage en réponse à la détection du défaut symétrique pendant la condition d'oscillation de puissance, pour protéger la ligne de transmission de puissance en réponse au défaut symétrique, le signal de déblocage étant transmis via l'interface de sortie.

8. IED selon la revendication 7, pour calculer les grandeurs de phaseurs calculées pour la pluralité d'échantillons, le module d'élimination de tendance étant configuré pour :

sélectionner une moitié d'une pluralité de grandeurs de phaseurs de courant correspondant à la pluralité d'échantillons dans la fenêtre de mesure pour fournir les grandeurs de phaseurs de courant ; et
calculer les valeurs de phaseurs à tendances éliminées sur la base des grandeurs de phaseurs de courant sélectionnées, les valeurs de phaseurs à tendances éliminées étant calculées par la soustraction de la moyenne ou de la ligne de meilleur ajustement correspondant aux grandeurs de phaseurs de courant sélectionnées.

9. IED selon la revendication 7, le module de détection de défaut destiné à estimer la valeur de l'indicateur de défaut, étant configuré pour :

déterminer une somme de la pluralité de valeurs de phaseurs à tendances éliminées obtenues pour des phases du courant électrique triphasé en sommant pour chaque échantillon la valeur de phaseur à tendance éliminée dans les trois phases afin d'obtenir une pluralité de valeurs de phaseurs à tendances éliminées sommées ; et
obtenir une norme des valeurs de phaseurs à tendances éliminées sommées pour estimer la valeur de l'indicateur de défaut, la norme des valeurs de phaseurs à tendances éliminées sommées étant basée sur l'équation suivante :

$$NSDPM(k) = [SDPM(k) \, X \, SDPM(k)^T]^{\frac{1}{2}},$$

dans laquelle
NSDPM est la valeur de l'indicateur de défaut et représente la norme des SDPM ; et
dans laquelle SDPM désigne les valeurs de phaseurs à tendances éliminées sommées.

10. IED selon la revendication 7, la valeur d'un indicateur de défaut se situant dans une plage allant d'environ 0,03 à environ 0,1.

100

IED 112
FAULT DETECTION MODULE 114

108

110-2
110-N
104
102
110-1
110-3
106

FIG. 1

INTELLIGENT ELECTRONIC DEVICE(S) 112

PROCESSOR(S) 202

INTERFACE(S) 204

MEMORY(S) 206

MODULE(S) 208

PHASE CURRENT SAMPLING MODULE 212

PHASOR ESTIMATION MODULE 214

FAULT DETECTION MODULE 114

DETRENDING MODULE(S) 216

BLOCK SIGNAL GENERATOR(S) 218

OTHER MODULE(S) 220

DATA 210

PHASOR MAGNITUDE(S) 222

DETRENDED PHASOR MAGNITUDE(S) 224

SDPM 226

NORMALIZED SDPM 228

PREDEFINED THRESHOLD VALUE(S) 230

OTHER DATA(S) 232

OTHER COMPONENT(S) 234

# FIG. 2

FIG. 3

**(A)**

**(B)**

FIG. 4

FIG. 5

(A)

(B)

FIG. 6

FIG. 7

800

| OBTAINING A FIRST SET COMPRISING A NUMBER OF PHASOR MAGNITUDES OF A THREE-PHASE CURRENT, WHEREIN THE PHASOR MAGNITUDES ARE DETERMINED OVER A POWER CYCLE PERTAINING TO THE THREE-PHASE CURRENT | 802 |

| OBTAINING A SECOND SET, FROM AMONGST THE FIRST SET, WITH THE SECOND SET COMPRISES AT LEAST HALF OF THE NUMBER OF PHASOR MAGNITUDES FOR EACH PHASE | 804 |

| DETRENDING THE SECOND SET OF THE PHASOR MAGNITUDES TO OBTAIN A SET OF DETRENDED PHASOR MAGNITUDES | 806 |

| SUMMING THE ELEMENTS OF THE SET OF THE DETRENDED PHASOR MAGNITUDES TO OBTAIN A SUM OF THE DETRENDED PHASOR MAGNITUDES | 808 |

| DETERMINING A NORM OF THE SUM OF THE DETRENDED PHASOR MAGNITUDES TO OBTAIN A NORMED SUM OF THE DETRENDED PHASOR MAGNITUDE (NSDPM) | 810 |

| DETECTING OCCURRENCE OF A SYMMETRIC FAULT DURING A POWER SWING, BASED ON THE NSDPM | 812 |

| UNBLOCKING THE IED FROM TRIPPING CIRCUIT BREAKERS IN THE EVENT OF OCCURRENCE OF THE SYMMETRIC FAULT BASED ON THE DETECTING | 814 |

# FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160299187 A1